# EUROPEAN PATENT APPLICATION

(11) **EP 4 394 647 A1**
(43) Date of publication of application: **03.07.2024**
(21) Application number: 23866627.5
(22) Date of filing: 18.05.2023
(51) Int. Cl.: G06F 30/39

(54) **AIR-BRIDGE LAYING METHOD AND APPARATUS FOR CHIP LAYOUT, DEVICE AND STORAGE MEDIUM**

(30) Priority: 30.09.2022 CN 202211230964
(71) Applicant: Tencent Technology (Shenzhen) Company Limited, Shenzhen, Guangdong, 518057 (CN)
(72) Inventor: LI, Yanghepu, Shenzhen, Guangdong 518057 (CN); MA, Shengming, Shenzhen, Guangdong 518057 (CN); WANG, Jianming, Shenzhen, Guangdong 518057 (CN); HUAI, Sainan, Shenzhen, Guangdong 518057 (CN); ZHANG, Shengyu, Shenzhen, Guangdong 518057 (CN); HUANG, Zhao, Shenzhen, Guangdong 518057 (CN); XU, Xiong, Shenzhen, Guangdong 518057 (CN)
(74) Representative: Gunzelmann, Rainer
(86) International application number: PCT/CN2023/094968
(87) International publication number: WO 2024/066398

(57) **Abstract**

This application provides an airbridge arrangement method and apparatus for a chip layout, a device, and a storage medium, and in particular, relates to the field of chip technologies. The method includes: obtaining a coplanar waveguide (CPW) point set in the chip layout, where the CPW point set includes location information of n points for defining a CPW arranged in the chip layout, and n is an integer greater than 1 (210); determining a skeleton line of the CPW according to the location information of the n points in the CPW point set, where the skeleton line of the CPW is a center line of a center conductor of the CPW (220); and arranging airbridges on the chip layout according to the skeleton line of the CPW (230). In this application, the skeleton line of the CPW is automatically recognized and the airbridges are automatically arranged, thereby improving the universality of the airbridge arrangement method for a chip layout.

## Description

### RELATED APPLICATION

This application claims priority to Chinese Patent Application No. 202211230964.6, entitled "AIRBRIDGE ARRANGEMENT METHOD AND APPARATUS FOR CHIP LAYOUT, DEVICE, AND STORAGE MEDIUM" and filed on September 30, 2022, which is incorporated herein by reference in its entirety.

### FIELD OF THE TECHNOLOGY

Embodiments of the invention relate to the field of chip technologies, and in particular, to an airbridge arrangement method and apparatus for a chip layout, a device, and a storage medium.

### BACKGROUND OF THE DISCLOSURE

Due to an asymmetric, discontinuous, or curved coplanar waveguide (CPW) in a superconducting quantum chip, a parasitic mode may be generated in a circuit, affecting line transmission characteristics. A most commonly used method for suppressing the parasitic mode in the CPW is to lay airbridges along the CPW.

In the related art, an airbridge arrangement method for a chip layout is provided, where airbridges may be arranged along a preset CPW skeleton line. A feature of this method is that arrangement of the airbridges is completed based on coordinate information of the preset CPW skeleton line. By presetting one or more CPW skeleton lines, a layout design tool may automatically place airbridges along the CPW skeleton lines.

However, in the related art, CPW skeleton lines need to be preset, leading to low airbridge arrangement efficiency.

### SUMMARY

Embodiments of the invention provide an airbridge arrangement method and apparatus for a chip layout, a device, and a storage medium. The technical solutions are as follows:

According to an aspect of the embodiments of the invention, an airbridge arrangement method for a chip layout is provided, executable by a computer device, the method including:
obtaining a coplanar waveguide (CPW) point set in the chip layout, the CPW point set including location information of n points for defining a CPW arranged in the chip layout, and n being an integer greater than 1;
determining a skeleton line of the CPW according to the location information of the n points included in the CPW point set, the skeleton line of the CPW being a center line of a center conductor of the CPW; and
arranging airbridges on the chip layout according to the skeleton line of the CPW.

According to an aspect of the embodiments of the invention, an airbridge arrangement apparatus for a chip layout is provided, including:
an obtaining module, configured to obtain a coplanar waveguide (CPW) point set in the chip layout, the CPW point set including location information of n points for defining a CPW arranged in the chip layout, and n being an integer greater than 1;
a determining module, configured to determine a skeleton line of the CPW according to the location information of the n points included in the CPW point set, the skeleton line of the CPW being a center line of a center conductor of the CPW; and
an arrangement module, configured to arrange airbridges on the chip layout according to the skeleton line of the CPW.

According to an aspect of the embodiments of the invention, a computer device is provided, including a processor and a memory, the memory having a computer program stored therein, and the processor being configured to execute the computer program to implement the foregoing method.

According to an aspect of the embodiments of the invention, a computer-readable storage medium is provided, having a computer program stored therein, the computer program being loaded and executed by a processor to implement the foregoing method.

According to an aspect of the embodiments of the invention, a computer program product is provided, including a computer program, the computer program being loaded and executed by a processor to implement the foregoing method.

The technical solutions provided in the embodiments of the invention may bring the following beneficial effects:

For a chip layout on which a CPW has been arranged, a skeleton line of the CPW may be automatically determined according to location information of points included in a CPW point set corresponding to the chip layout, and airbridges are then arranged on the chip layout according to the skeleton line of the CPW. Therefore, location information of the skeleton line of the CPW does not need to be manually inputted, and the skeleton line of the CPW is automatically recognized and the airbridges are automatically arranged, thereby improving the efficiency of airbridge arrangement on a chip layout.

In addition, the skeleton line of the CPW does not need to be preset manually in the technical solutions provided in the embodiments of the invention, the universality of airbridge arrangement on a chip layout is improved.

### BRIEF DESCRIPTION OF THE DRAWINGS

FIG. 1 is a schematic diagram of curved, discontinuous, and asymmetric CPWs according to an embodiment of the invention;
FIG. 2 is a flowchart of an airbridge arrangement method for a chip layout according to an embodiment of the invention;
FIG. 3 is a schematic structural diagram of a CPW according to an embodiment of the invention;
FIG. 4 is a schematic diagram of a CPW point set according to an embodiment of the invention;
FIG. 5 is a schematic diagram of a CPW point set according to another embodiment of the invention;
FIG. 6 is a schematic diagram of a skeleton line of a CPW according to an embodiment of the invention;
FIG. 7 is a schematic diagram of arranging airbridges according to a skeleton line according to an embodiment of the invention;
FIG. 8 is a schematic structural diagram of a chip layout on which airbridges have been arranged according to an embodiment of the invention;
FIG. 9 is a flowchart of an airbridge arrangement method for a chip layout according to another embodiment of the invention;
FIG. 10 is a schematic diagram of types of a point according to an embodiment of the invention;
FIG. 11 is a schematic diagram of a CPW straight line segment group and a CPW arc line segment group according to an embodiment of the invention;
FIG. 12 is a schematic structural diagram of an airbridge according to an embodiment of the invention;
FIG. 13 is a flowchart of a method for determining a skeleton line segment of a CPW according to an embodiment of the invention;
FIG. 14 is a schematic diagram of determining a CPW straight line segment group and a CPW arc line segment group according to a type and location information of each point according to an embodiment of the invention;
FIG. 15 is a schematic diagram of determining a CPW straight line segment group and a CPW arc line segment group according to a type and location information of each point according to another embodiment of the invention;
FIG. 16 is a schematic diagram of determining a starting CPW arc line segment according to an embodiment of the invention;
FIG. 17 is a block diagram of an airbridge arrangement method for a chip layout according to an embodiment of the invention;
FIG. 18 is a schematic diagram of a method for determining an arc parameter and a circle center parameter according to an embodiment of the invention;
FIG. 19 is a schematic diagram of an airbridge arrangement method for a chip layout according to an embodiment of the invention;
FIG. 20 is a block diagram of an airbridge arrangement apparatus for a chip layout according to an embodiment of the invention;
FIG. 21 is a block diagram of an airbridge arrangement apparatus for a chip layout according to another embodiment of the invention; and
FIG. 22 is a structural block diagram of a computer device according to an embodiment of the invention.

### DESCRIPTION OF EMBODIMENTS

To make the objectives, technical solutions, and advantages of the invention clearer, the following further describes implementations of the invention in detail with reference to the accompanying drawings.

Before the embodiments of the invention are introduced and described, some terms related to the invention are first explained and described.
1. Superconducting quantum chip: It is a central processing unit of a superconducting quantum computer. A quantum computer is a machine perform computing by using the principle of quantum mechanics. Based on the superposition principle and quantum entanglement of quantum mechanics, the quantum computer has a strong parallel processing capability, and can resolve some problems that can be hardly computed by a classical computer. Due to the zero resistance characteristic of superconducting qubits and a manufacturing process similar to an integrated circuit, a quantum computing architecture constructed by using superconducting qubits is one architecture that is most likely to implement practical quantum computing.
2. Coplanar waveguide (CPW): It includes a central conductor (center conductor) located on a substrate and coplanar ground layers located on two sides of the center conductor, is a microwave planar transmission line that is superior in performance and easy to process, and is configured to transmit a microwave signal. A lots of coplanar waveguide technologies are used in a superconducting quantum chip.
3. Airbridge: It is a circuit structure that implements planar circuit bridging in a form of a three-dimensional bridge, so that potentials of ground located on two sides of a center conductor are equal to each other, and excitation of a parasitic mode is suppressed. The airbridge is applicable to various chips, and particularly applicable to a flip-chip soldering chip or a superconducting quantum chip. A medium between a bridge and a circuit is air or vacuum, so that the bridge is referred to as an air bridge or a vacuum bridge, and generally, is also referred to as an airbridge.
4. Automatic routing: This automatically completes arrangement of lines in a circuit or a chip design by using software, and connects elements according to rules and requirements. The automatic routing is mostly used in large-scale and ultra-large-scale integrated circuit designs and is one loop thereof, and is generally performed after layout arrangement is completed.
5. Layout: It is also referred to as a circuit layout, is a design drawing for describing how elements in a circuit are laid, placed, and connected, and describes a planar geometric shape of a real physical situation of the circuit. A design of the layout conforms to constraints such as a manufacturing process, a time sequence, an area, and power consumption. A layout design file includes information such as a shape, an area, and a location of each hardware unit on a chip.
6. Skeleton line: It is configured for describing a center line of a center conductor of a CPW in the invention.

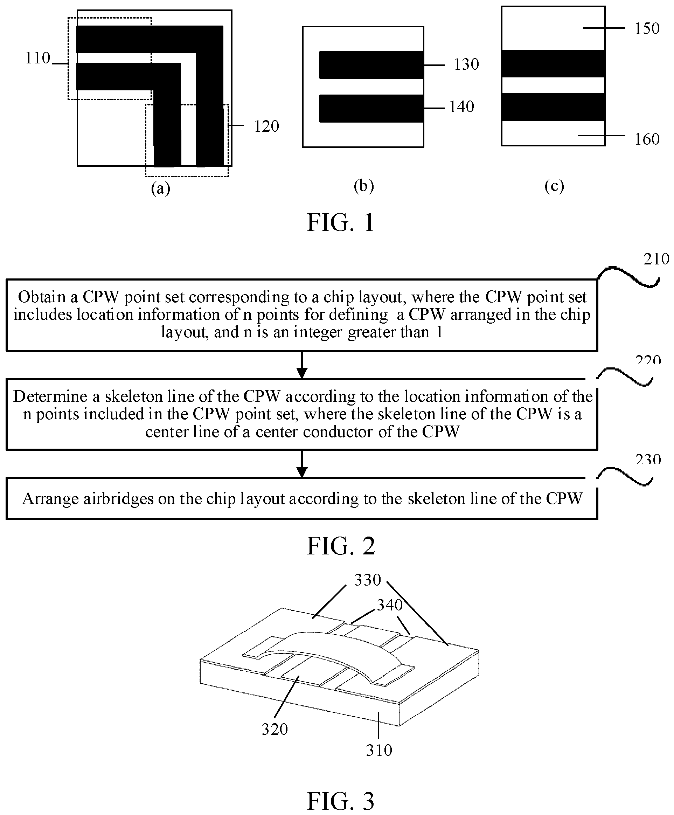

Due to an asymmetric, discontinuous, or curved CPW in a superconducting quantum chip, a parasitic mode may be generated in a circuit, affecting line transmission characteristics. FIG. 1 is a schematic diagram of the foregoing several cases. In FIG. 1, two parallel black lines having a width are CPW gaps (or referred to as gaps for short). A curved CPW means that the CPW is bent and is not laid along a straight line. As shown in FIG. 1(a), the CPW is bent, a CPW 110 part and a CPW 120 part are perpendicular to each other. A discontinuous CPW means that ends of CPWs are not connected but disconnected. As shown in FIG. 1(b), a CPW 130 and a CPW 140 are not connected. An asymmetric CPW means that ground planes on two sides of the CPW are asymmetric. As shown in FIG. 1(c), a ground plane 150 and a ground plane 160 are asymmetric. A most commonly used method for suppressing the parasitic mode in the CPW is to arrange airbridges along the CPW.

In the related art, when a user designs a chip layout by using a layout design tool, the user needs to input a skeleton line of a CPW first, and the layout design tool then uses an airbridge arrangement function to implement airbridge arrangement on the chip layout based on location information of the skeleton line of the CPW inputted by the user. This airbridge arrangement method for a chip layout cannot process a chip layout without a preset skeleton line.

Based on this, the invention provides an airbridge arrangement method for a chip layout. In the method, the user does not need to input a skeleton line of a CPW, and the skeleton line of the CPW may be automatically recognized and airbridges may be automatically arranged based only on the chip layout, so that highly automated airbridge arrangement on the chip layout is implemented, and the method can be applicable to more usage scenarios.

FIG. 2 is a flowchart of an airbridge arrangement method for a chip layout according to an embodiment of the invention. The method may be performed by a computer device, and the computer device may be any electronic device that has computing and storage capabilities, such as a personal computer (PC), a tablet computer, or a server. For example, a computer program for implementing the method may be run in the computer device, and the airbridge arrangement method for a chip layout provided in this embodiment is implemented through the computer program. As shown in FIG. 2, the method may include at least one step of step 210 to step 230.

Step 210. Obtain a CPW point set corresponding to the chip layout, where the CPW point set includes location information of n points of a CPW arranged in the chip layout, and n is an integer greater than 1.

The chip layout is a design drawing for describing how elements in a circuit are laid, placed, and connected, and describes a planar geometric shape of a real physical situation of the circuit. The chip layout may be a chip layout of a quantum chip, such as a chip layout of a superconducting quantum chip. A lots of coplanar waveguide technologies are used in the superconducting quantum chip to transmit a microwave signal. The chip layout may alternatively be a chip layout of another chip, for example, a chip layout of a storage chip or a chip layout of a digital multimedia chip. A chip type corresponding to the chip layout is not limited in the invention.

A layout design file of the chip layout includes information such as a shape, an area, and a location of each hardware unit on a chip. Through automatic routing, routing information at each point may be added and connected in the layout design file, to finally generate a layout design file carrying the routing information. The routing information may include a CPW point set, which defines location information of a plurality of points of a CPW arranged in the chip layout.

A center conductor is manufactured on a surface of a dielectric substrate, and ground planes are manufactured on two sides adjacent to the center conductor, to form a CPW, which is also referred to as a coplanar microstrip transmission line. The CPW includes two parallel gaps having a width. In the chip layout, grooves (that is, gaps) between the center conductor and the ground planes located on two sides are generally drawn. Generally speaking, spaces between the center conductor and the ground planes located on two sides are the same, which means that widths of the two gaps drawn in the chip layout are the same.

As shown in FIG. 3, a center conductor 320 and ground planes 330 located on two sides of the center conductor 320 exist on a surface of a dielectric substrate 310, and the center conductor 320, two gaps (grooves) 340 between the center conductor 320 and the ground planes 330 located on two sides, and the ground planes 330 located on two sides jointly form a CPW. That is, on one hand, the CPW in the invention may be broadly understood as including a conductor (the center conductor and the ground planes located on two sides) and two gaps, and on the other hand, the CPW may be narrowly understood as including only two gaps. In the following embodiments, the CPW point set may be narrowly understood as a point set for two gaps.

The CPW point set includes location information of n points for defining a CPW arranged in a chip layout. The n points are points obtained through sampling along the CPW, so that a line of the CPW may be drawn according to the location information of the n points. In some embodiments, sampling may be performed along the CPW at equal distances, to obtain the location information of the n points of the CPW. For example, sampling is performed along the CPW at an equal distance of 1 micrometer to obtain the location information of the n points of the CPW. In some embodiments, sampling may alternatively be performed along the CPW at non-equal distances, to obtain the location information of the n points of the CPW. A sampling distance at a straight line part of the CPW may be greater than a sampling distance at an arc line part. For example, sampling is performed on the straight line part of the CPW at a distance of 2 micrometers, and sampling is performed is performed on the arc line part at a distance of 1 micrometer, to obtain the location information of the n points of the CPW.

In some embodiments, the location information of the n points of the CPW may be represented in the form of coordinates. For example, a two-dimensional coordinate system is established by using a center of the chip layout as an origin, and the location information of the n points of the CPW is represented in the form of two-dimensional coordinates (x, y).

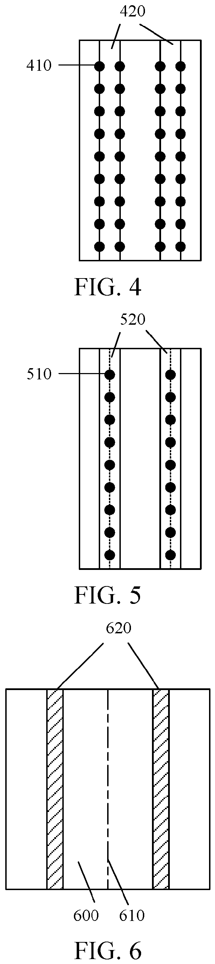

In some embodiments, each point in the CPW point set is located at an edge of a CPW gap having a width. The edge of the gap is a boundary of the gap having a width. For example, as shown in FIG. 4, a CPW includes two parallel gaps 420, little black dots in the figure are points 410 in the CPW point set, which are located at edges on two sides of the gaps 420 having a width.

In some embodiments, each point in the CPW point set is located on a center line of a gap having a width. The center line of the gap is a line configured for identifying a center of the gap having a width, and a distance from any point located at edges on two sides of the gap to the center line of the gap is the same. For example, as shown in FIG. 5, a CPW includes two parallel gaps 520, little black dots in the figure are points 510 in the CPW point set, which are located on center lines of the gaps 520 having a width.

In the embodiments of the invention, a location of each point in the CPW point set in the gap is not limited. The point may be located on a center line of each gap, or may be located at edges on two sides of each gap, or may be located at another location of a region in which each gap is located. In some embodiments, the location of the point is a location at which a ratio of distances from the point to two edge lines on two sides of the gap is 1:2.

Step 220. Determine a skeleton line of the CPW according to the location information of the n points included in the CPW point set, where the skeleton line of the CPW is a center line of a center conductor of the CPW.

Locations of the two parallel gaps included in the CPW may be determined according to the location information of the n points included in the CPW point set, and the skeleton line of the CPW may be further determined.

A center line of the two parallel gaps is a line configured for identifying a center of the two parallel gaps, and a distance from any point located on a center line of each gap to the center line of the two parallel gaps is the same. For example, as shown in FIG. 6, a skeleton line 610 of a CPW is a center line of a center conductor 600 of the CPW. In some embodiments, the skeleton line 610 of the CPW is a center line of two parallel gaps 620 included in the CPW.

Step 230. Arrange airbridges on the chip layout according to the skeleton line of the CPW.

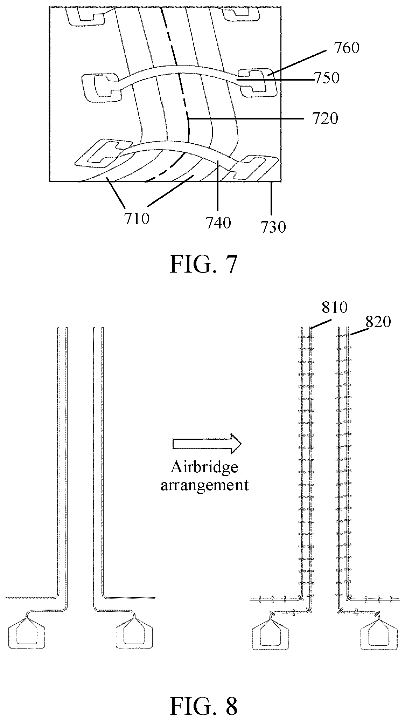

In some embodiments, airbridges for connecting ground planes on two sides of the CPW are arranged on the CPW by using the skeleton line of the CPW as a center line. For example, as shown in FIG. 7, airbridges 740 are arranged on a chip layout 730 according to a skeleton line 720 of a CPW 710. A chip layout on which airbridge arrangement is completed is shown in FIG. 8, where 810 is a CPW, and 820 is an airbridge.

In some embodiments, airbridges are arranged on the chip layout at equal distances along the skeleton line of the CPW. For example, airbridges are arranged on the CPW at an interval of a same distance by using the skeleton line of the CPW as a center line. For example, one airbridge is arranged on the CPW at an interval of 20 micrometers by using the skeleton line of the CPW as a center line.

In some embodiments, airbridges are arranged on the chip layout at non-equal distances along the skeleton line of the CPW. For example, airbridges are arranged on the CPW at an interval of a random distance by using the skeleton line of the CPW as a center line. For example, by using the skeleton line of the CPW as a center line, one airbridge is arranged on the CPW at an interval of 20 micrometers, and another airbridge is arranged on the CPW at an interval of 40 micrometers.

In some embodiments, along the skeleton line of the CPW, airbridges are arranged on a straight line segment of the CPW at an interval of a first distance, and airbridges are arranged on an arc line segment of the CPW at an interval of a second distance, where the first distance may be greater than the second distance. For example, along the skeleton line of the CPW, one airbridge is arranged on the straight line segment of the CPW at an interval of 40 micrometers, and one airbridge is arranged on the arc line segment of the CPW at an interval of 20 micrometers. The straight line segment of the CPW and the arc line segment of the CPW are determined according to a straight or curved gap. In some embodiments, when the gap is a straight line, it is considered that the CPW is a straight line; and when the gap is an arc line, it is considered that the CPW is an arc line.

According to the technical solutions provided in the embodiments of the invention, for a chip layout on which a CPW has been arranged, a skeleton line of the CPW may be automatically determined according to location information of points included in a CPW point set corresponding to the chip layout, and airbridges are then arranged on the chip layout according to the skeleton line of the CPW. Therefore, location information of the skeleton line of the CPW does not need to be preset, and the skeleton line of the CPW is automatically recognized and the airbridges are automatically arranged, thereby improving the efficiency of the airbridge arrangement method for a chip layout.

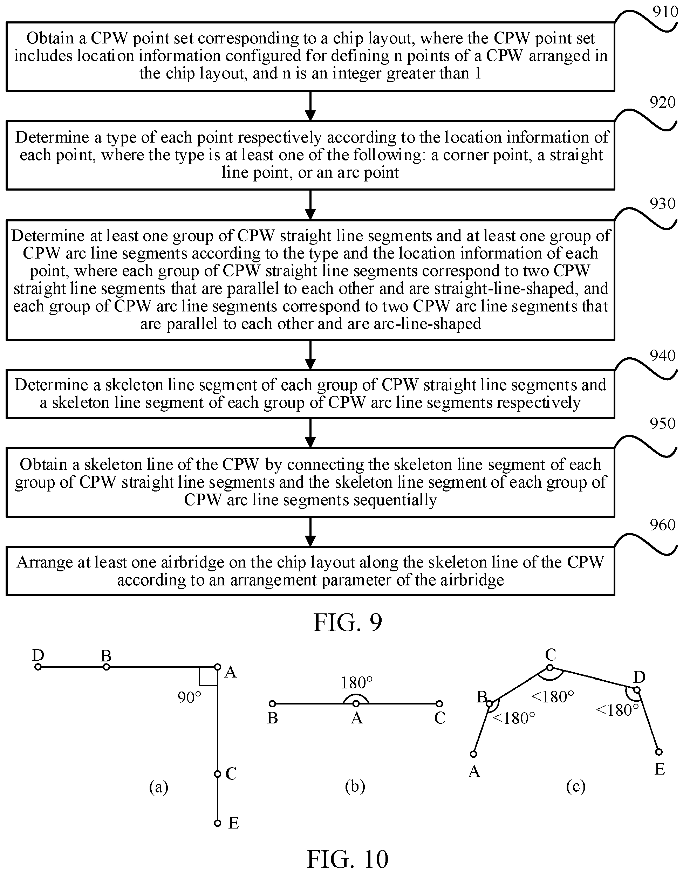

FIG. 9 is a flowchart of an airbridge arrangement method for a chip layout according to another embodiment of the invention. The method may be performed by a computer device. The method may include at least one step of step 910 to step 960.

Step 910. Obtain a CPW point set corresponding to the chip layout, where the CPW point set includes location information of n points of a CPW arranged in the chip layout, and n is an integer greater than 1.

Step 910 is the same as step 210 in the foregoing embodiment, and details are not described herein again.

Step 920. Determine a type of each point respectively according to the location information of each point, where the type is at least one of the following: a corner point, a straight line point, or an arc point.

For each point, a type of the point may be determined according to location information of the point and location information respectively corresponding to at least two adjacent points. The adjacent point is a point adjacent to the point in the CPW point set. In some embodiments, the point adjacent to the point is a point that is closest to the point in the CPW point set. For example, in FIG. 10(a), a point B and a point C are two adjacent points of a point A.

The straight line point is a point located on a straight line segment of the CPW, that is, a point whose connection lines with two adjacent points form a straight angle. As shown in FIG. 10(b), an angle formed by connection lines between a point A and two adjacent points (a point B and a point C) is 180 degrees, so that the point A is a straight line point.

The corner point is a point located at a corner of the CPW, that is, a point that is a non-straight line point and whose two adjacent points are straight line points. As shown in FIG. 10(a), an angle formed by connection lines between the point A and the two adjacent points (the point B and the point C) is not 180 degrees, an angle formed by connection lines between the point B and two adjacent points (the point A and a point D) is 180 degrees, and an angle formed by connection lines between the point C and two adjacent points (the point A and a point E) is 180 degrees, so that the point A is a corner point.

The arc point is a point located on an arc line segment of the CPW, that is, a point that the current point and two adjacent points are all not straight line points. As shown in FIG. 10(c), an angle formed by connection lines between a point B and two adjacent points (a point A and a point C) is apparently less than 180 degrees, an angle formed by connection lines between the point C and two adjacent points (the point B and a point D) is less than 180 degrees, and an angle formed by connection lines between the point D and two adjacent points (the point C and a point E) is also less than 180 degrees, so that the point C is an arc point.

Step 930. Determine at least one group of CPW straight line segments and at least one group of CPW arc line segments according to the type and the location information of each point, where each group of CPW straight line segments correspond to two CPW straight line segments that are parallel to each other and are straight-line-shaped, and each group of CPW arc line segments correspond to two CPW arc line segments that are parallel to each other and are arc-line-shaped.

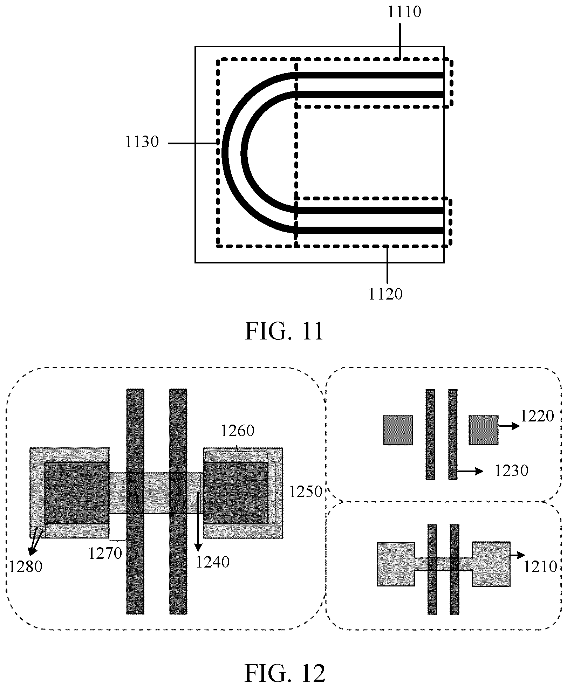

For example, as shown in FIG. 11, two groups of CPW straight line segments 1110 and 1120 and one group of CPW arc line segments 1130 are determined according to the type and the location information of each point.

In some embodiments, according to the type and the location information of each point, a line segment in which a plurality of consecutive straight line points are located is determined as one straight line segment, and an arc line in which a plurality of consecutive arc points are located is determined as one arc line segment; the at least one group of CPW straight line segments are determined according to locations and a parallel relationship of straight line segments; and the at least one group of CPW arc line segments are determined according to locations and a parallel relationship of arc line segments.

For example, the at least one group of CPW straight line segments are determined according to the parallel relationship of the straight line segments and a distance between parallel straight line segments; and the at least one group of CPW arc line segments are determined according to the parallel relationship of the arc line segments and a distance between parallel arc line segments (that is, a difference between radii respectively corresponding to the parallel arc line segments) and circle center locations of the parallel arc line segments (arc line segments in one group of CPW arc line segments have the same circle center location).

Step 940. Determine a skeleton line segment of each group of CPW straight line segments and a skeleton line segment of each group of CPW arc line segments respectively.

In some embodiments, for each group of CPW straight line segments, a center line of two CPW straight line segments that are parallel to each other and are straight-line-shaped corresponding to the group of CPW straight line segments is determined as a skeleton line segment of the group of CPW straight line segments; and for each group of CPW arc line segments, a center line of two CPW arc line segments that are parallel to each other and are arc-line-shaped corresponding to the group of CPW arc line segments is determined as a skeleton line segment of the group of CPW arc line segments.

Step 950. Obtain a skeleton line of the CPW by connecting the skeleton line segment of each group of CPW straight line segments and the skeleton line segment of each group of CPW arc line segments sequentially.

In some embodiments, the skeleton line segment of each group of CPW straight line segments and the skeleton line segment of each group of CPW arc line segments are connected sequentially according to a sequence of each group of CPW straight line segments and each group of CPW arc line segments, to obtain the skeleton line of the CPW.

In some embodiments, a connection sequence of the skeleton line segments is determined according to parameter information of each CPW arc line segment, where the parameter information of each CPW arc line segment includes an arc parameter and a circle center parameter, the arc parameter indicates an arrangement sequence of points included in the CPW arc line segment, and the circle center parameter indicates a circle center location corresponding to the CPW arc line segment; and the skeleton line of the CPW is obtained by connecting the skeleton line segment of each group of CPW straight line segments and the skeleton line segment of each group of CPW arc line segments sequentially according to the connection sequence.

In some embodiments, to determine the connection sequence of the skeleton line segments, a starting skeleton line segment needs to be first determined. In some embodiments, a starting CPW arc line segment is determined according to the parameter information of each CPW arc line segment. In some embodiments, the arc parameter of the arc line segment includes an arrangement sequence of points, so that a starting point may be determined, and the starting CPW arc line segment may be further determined. The connection sequence of the skeleton line segments is determined according to the starting CPW arc line segment and an arrangement sequence of the CPW arc line segments. The starting skeleton line segment is a starting point of the connection sequence of the skeleton line segments. Because CPW arrangement on a chip layout is relatively complex, the connection sequence of the skeleton line segments may be easily misjudged, so that the starting CPW arc line segment needs to be determined. According to the technical solution provided in this embodiment of the invention, the starting CPW arc line segment is determined according to the parameter information of each arc line segment, so that the determined CPW arc line segment is relatively accurate, which further facilitates subsequent skeleton line segment connection, and improves the accuracy of airbridges arranged according to the skeleton line. In addition, in this embodiment of the invention, the skeleton line segments respectively corresponding to each group of CPW straight line segments and each group of CPW arc line segments are determined according to straight lines in each group of CPW straight line segments and arc lines in each group of CPW arc line segments when the skeleton line segments are determined, so that the accuracy of the determined skeleton line segments is improved.

Step 960. Arrange at least one airbridge on the chip layout along the skeleton line of the CPW according to an arrangement parameter of the airbridge.

In some embodiments, at least one airbridge is arranged on the chip layout along the skeleton line of the CPW according to the arrangement parameter of the airbridge, and the arrangement parameter of the airbridge defines a size of a bridge portion and a size of a pier portion of the airbridge, and a relative location relationship between the bridge portion and the pier portion. The bridge portion of the airbridge is a conductor spanning the CPW to connect ground planes on two sides of the CPW, and the pier portion of the airbridge is a conductor connecting the bridge portion of the airbridge and the ground planes on two sides of the CPW, and the bridge portion and the pier portion of the airbridge have different materials.

In some embodiments, the arrangement parameter of the airbridge includes: a width of the bridge portion, a width of the pier portion, a length of the pier portion, a distance between the bridge portion and a gap, and a distance between the bridge portion and the pier portion. The width of the bridge portion is a width of the bridge portion spanning the CPW. The width of the pier portion is a side length of a side of the pier portion parallel to the CPW. The length of the pier portion is a side length of a side of the pier portion perpendicular to the CPW. The distance between the bridge portion and a gap is a distance between a side of the bridge portion that is close to the CPW and an edge of the CPW that is close to the bridge portion. The distance between the bridge portion and the pier portion is a distance between a side of the bridge portion that is close to the pier portion and a side of the pier portion.

In some embodiments, the arrangement parameters such as the width of the bridge portion, the width of the pier portion, the length of the pier portion, the distance between the bridge portion and a gap, and the distance between the bridge portion and the pier portion of each airbridge are preset. In some embodiments, airbridges are arranged at a fixed interval. In some embodiments, the fixed interval is 3 cm, a length of the skeleton line is 20 cm, and one airbridge is arranged on the skeleton line whose length is 20 cm at an interval of 3 cm.

According to the technical solution provided in this embodiment of the invention, the arrangement parameter is preset, and at least one airbridge is arranged along the skeleton line of the CPW, so that the arranged airbridge can meet a user's requirement, thereby improving the flexibility and accuracy of airbridge arrangement.

In addition, the arrangement parameter includes the width of the bridge portion, the width of the pier portion, the length of the pier portion, the distance between the bridge portion and a CPW gap, and the distance between the bridge portion and the pier portion, which is relatively comprehensive, so that an accuracy degree of the arranged airbridge is relatively high.

For example, as shown in FIG. 12, an airbridge includes two parts: a pier portion 1220 and a bridge portion 1210, and the arrangement parameter of the airbridge includes: a width 1240 of the bridge portion 1210, a width 1250 of the pier portion 1220, a length 1260 of the pier portion 1220, a distance 1270 between the bridge portion 1210 and a gap 1230, and a distance 1280 between the bridge portion 1210 and the pier portion 1220.

In some embodiments, the arrangement parameter of the airbridge may be customized by a user, or may be automatically generated, which is not limited in the invention.

For example, the user may customize the arrangement parameter of the airbridge through a protobuf protocol.

For example, the user may customize the arrangement parameter of the airbridge by using the following program.

```
             message Airbridge (airbridge) {
             message Airbridge_FixedProperty {
             double bridgeWidth = 1; // the width of middle bridge (defining the width of the
 bridge)
             double bridgePierCocoon = 2; // the different size that between the Pier and the
             Bridge (defining the distance between the bridge and the pier)
             }
             message Pier (pier) {
             double pierWidth = 1; // pier width (defining the width of the pier)
             double pierLength = 2; // pier Length (defining the length of the pier)
             }
             message Bridge {
             double bridgeCPWCocoon = 1; // the length of middle bridge (defining the distance
 between the bridge and the gap)
             }
             Airbridge_FixedProperty airbridge_fixedproperty = 1; (a related property set for
 defining the bridge, and internal properties are shown by message Airbridge_FixedProperty)
             Pier pier = 2; (a related property set
for defining the pier, and internal properties are
 shown by message Pier)
             Bridge bridge = 3; (a property set
for defining a relationship between the airbridge
 and the CPW, and internal properties are shown by message Bridge)
             }
```

A size relationship between the bridge portion and the pier portion of the airbridge is not limited in the invention. In an example, as shown in FIG. 7, a size of a bridge portion 750 of an airbridge is less than a size of a pier portion 760. In another example, as shown in FIG. 12, a size of the bridge portion 1210 of the airbridge is greater than a size of the pier portion 1220.

According to the technical solution provided in this embodiment of the invention, the points in the CPW point set are classified, at least one group of CPW straight line segments and at least one group of CPW arc line segments are determined according to the type and the location information of each point, the skeleton line of each group of CPW straight line segments and the skeleton line of each group of CPW arc line segments are respectively determined, and the skeleton line of each group of CPW straight line segments and the skeleton line of each group of CPW arc line segments are connected sequentially to obtain the skeleton line of the CPW. The skeleton lines of the straight line segments and the skeleton lines of the arc line segments are respectively determined and are then connected sequentially, so that an error occurring in the skeleton line when the CPW has complex routing is avoided, thereby improving the accuracy in automatically recognizing the skeleton line.

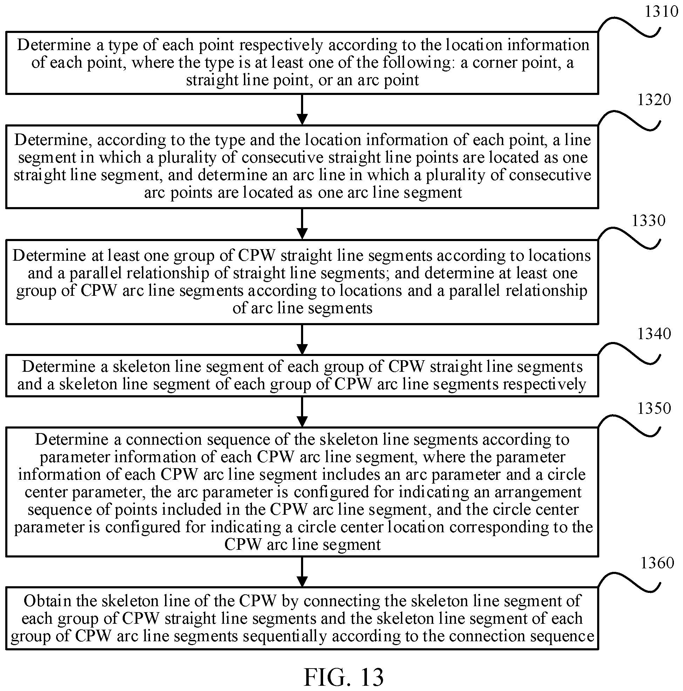

FIG. 13 is a flowchart of a method for determining a skeleton line segment of a CPW according to an embodiment of the invention. The method may include at least one step of step 1310 to step 1360.

Step 1310. Determine a type of each point respectively according to location information of each point, where the type is at least one of the following: a corner point, a straight line point, or an arc point.

Step 1320. Determine, according to the type and the location information of each point, a line segment in which a plurality of consecutive straight line points are located as one straight line segment, and determine an arc line in which a plurality of consecutive arc points are located as one arc line segment.

Step 1330. Determine at least one group of CPW straight line segments according to locations and a parallel relationship of straight line segments; and determine at least one group of CPW arc line segments according to locations and a parallel relationship of arc line segments.

In some embodiments, each point in the CPW point set is located at an edge of a CPW gap having a width.

Each group of CPW straight line segments include four straight line segments that are parallel to each other, two of the four straight line segments are located at two edges of one gap, and the other two of the four straight line segments are located at two edges of another gap.

According to the technical solution provided in this embodiment of the invention, a plurality of straight line segments and a plurality of arc line segments are determined according to a CPW point set based on a type and location information of each point. Further, one group of CPW straight line segments and one group of CPW arc line segments that respectively belong to the same gap are determined. Therefore, in this embodiment of the invention, the accuracy of a determined CPW line is improved while the flexibility in determining the straight line segments and the arc line segments is ensured.

In addition, considering different distribution cases of the points in a point set on a gap, namely, distributed at an edge of the gap and distributed on a center line of the gap, each group of CPW straight line segments and each group of CPW arc line segments are respectively determined in two different manners. Therefore, for different sampling manners, the invention provides different manners for determining a line segment, so that the line segment is determined in a comprehensive and flexible manner.

Each group of CPW arc line segments include four arc line segments that are parallel to each other and have the same circle center, two of the four arc line segments are located at two edges of one gap, and the other two of the four arc line segments are located at two edges of another gap.

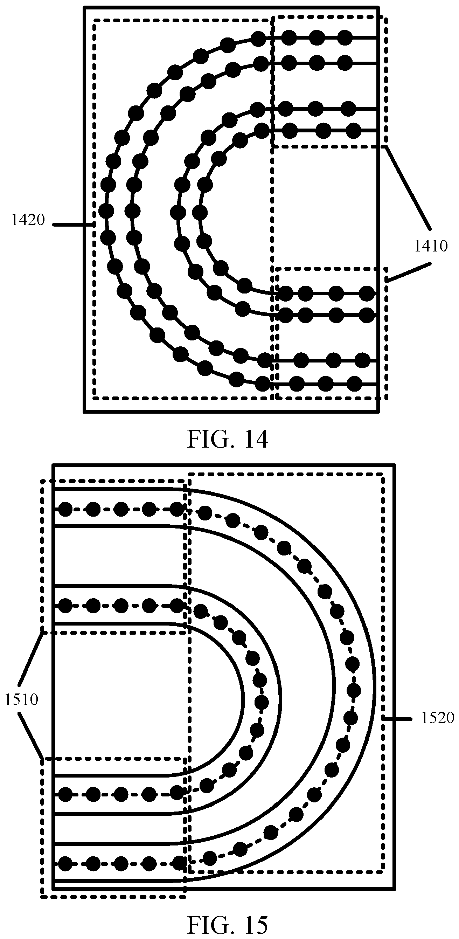

For example, as shown in FIG. 14, two groups of CPW straight line segments 1410 are shown, where each group of CPW straight line segments include four straight line segments that are parallel to each other, and the four straight line segments respectively form two CPW gaps; and one group of CPW arc line segments 1420 are shown, where each group of CPW arc line segments include four arc line segments that are parallel to each other and have the same circle center, and the four arc line segments respectively form two CPW gaps. For example, as shown in FIG. 15, two groups of CPW straight line segments 1510 are shown, where each group of CPW straight line segments include four straight line segments that are parallel to each other, and the four straight line segments respectively form two CPW gaps; and one group of CPW arc line segments 1520 are shown, where each group of CPW arc line segments include four arc line segments that are parallel to each other and have the same circle center, and the four arc line segments respectively form two CPW gaps. In some embodiments, at least one group of CPW straight line segments are determined according to distances between the straight line segments and a parallel relationship of the straight line segments. For example, at least one pair of straight line segments are determined according to a distance relationship of parallel straight line segments, each pair of straight line segments include two straight line segments, and the two straight line segments belong to the same gap. The two straight line segments in each pair of straight line segments are parallel to each other, and a distance between the two straight line segments in each pair of straight line segments is the same. The at least one group of CPW straight line segments are then determined according to a distance between center lines of each pair of parallel straight line segments, where the center line of each pair of straight line segments is a center line of a gap to which the pair of straight line segments belong. For example, four pairs of straight line segments (a pair 1, a pair 2, a pair 3, and a pair 4) are determined according to the distance relationship of the parallel straight line segments, which respectively correspond to four gaps (a line 1, a line 2, a line 3, and a line 4). Two straight line segments in each pair of straight line segments are parallel to each other, and distances between the two straight line segments in the pair 1, the pair 2, the pair 3, and the pair 4 (that is, widths of the line 1, the line 2, the line 3, and the line 4) are all 5 micrometers. The line 1, the line 2, the line 3, and the line 4 are parallel to each other, a distance between center lines of the line 1 and the line 2 is 15 micrometers, a distance between center lines of the line 3 and the line 4 is 15 micrometers, but a distance between center lines of the line 1 and the line 3 is 15 micrometers, and a distance between center lines of the line 2 and the line 4 is 345 micrometers, so that the straight line segments in the pair 1 and the pair 2 are determined as one group of CPW straight line segments, and the straight line segments in the pair 3 and the pair 4 are determined as one group of CPW straight line segments. In this embodiment of the invention, an example in which a ratio of widths of CPW gaps to a width of the center conductor is 1:2:1 is merely used, and in different electromagnetic environments, the ratio of the widths of the CPW gaps to the width of the center conductor may change according to an impedance requirement.

In some embodiments, at least one group of CPW arc line segments are determined according to distances between the arc line segments, a parallel relationship of the arc line segments, and circle center locations of the arc line segments. For example, at least one pair of arc line segments are determined according to a distance relationship of parallel arc line segments, each pair of arc line segments include two arc line segments, and the two arc line segments belong to the same gap. The two arc line segments in each pair of arc line segments are parallel to each other, and a distance between the two arc line segments in each pair of arc line segments is the same. The at least one group of CPW arc line segments are then determined according to a distance between center lines of each pair of parallel arc line segments and a circle center location of each pair of parallel arc line segments. For example, four pairs of arc line segments (a pair 1, a pair 2, a pair 3, and a pair 4) are determined according to the distance relationship of the parallel arc line segments, which respectively correspond to four gaps (an arc 1, an arc 2, an arc 3, and an arc 4). Two arc line segments in each pair of arc line segments are parallel to each other, and distances between the two arc line segments in the pair 1, the pair 2, the pair 3, and the pair 4 (that is, widths of the arc 1, the arc 2, the arc 3, and the arc 4) are all 5 micrometers. Center lines of the arc 1, the arc 2, the arc 3, and the arc 4 have the same circle center location, but the arc 1 and the arc 2 are parallel to each other, the arc 3 and the arc 4 are parallel to each other, and a distance between the center lines of the arc 1 and the arc 2 and a distance between the center lines of the arc 3 and the arc 4 are the same and are both 15 micrometers, so that the arc line segments in the pair 1 and the pair 2 are determined as one group of CPW arc line segments, and the arc line segments in the pair 3 and the pair 4 are determined as one group of CPW arc line segments.

In some embodiments, each point in the CPW point set is located on a center line of a gap having a width.

Each group of CPW straight line segments include two straight line segments that are parallel to each other, one of the two straight line segments is located on a center line of one gap, and the other of the two straight line segments are located on a center line of another gap.

Each group of CPW arc line segments include two arc line segments that are parallel to each other and have the same circle center, one of the two arc line segments is located on a center line of one gap, and the other of the two arc line segments is located on a center line of another gap.

In some embodiments, at least one group of CPW straight line segments are determined according to distances between the straight line segments and a parallel relationship of the straight line segments. For example, at least one group of CPW straight line segments are determined according to a distance relationship of parallel straight line segments. For example, 4 straight line segments (a straight line 1, a straight line 2, a straight line 3, and a straight line 4) are parallel to each other, a distance between the straight line 1 and the straight line 2 is 5 micrometers, a distance between the straight line 3 and the straight line 4 is also 5 micrometers, but a distance between the straight line 1 and the straight line 3 is 15 micrometers, and a distance between the straight line 2 and the straight line 4 is 25 micrometers, so that the straight line 1 and the straight line 2 are determined as one group of CPW straight line segments, and the straight line 3 and the straight line 4 are determined as one group of CPW straight line segments.

In some embodiments, at least one group of CPW arc line segments are determined according to distances between the arc line segments, a parallel relationship of the arc line segments, and circle center locations of the arc line segments. For example, at least one group of CPW arc line segments are determined according to a distance relationship of parallel arc line segments and circle center locations of the parallel arc line segments. For example, four arc line segments (an arc 1, an arc 2, an arc 3, and an arc 4) are parallel to each other, the arc 1 and the arc 2 have the same circle center location, the arc 3 and the arc 4 have the same circle center location, but the arc 1 and the arc 3 have different circle center locations, so that the arc 1 and the arc 2 are determined as one group of CPW arc line segments, and the arc 3 and the arc 4 are determined as one group of CPW arc line segments.

A straight line segment that is not classified as any group of CPW straight line segments and an arc line segment that is not classified as any group of CPW arc line segments are not considered when the skeleton line segment of each group of CPW straight line segments and the skeleton line segment of each group of CPW arc line segments are determined, so that the straight line segment and the arc line segment are excluded.

Step 1340. Determine a skeleton line segment of each group of CPW straight line segments and a skeleton line segment of each group of CPW arc line segments respectively.

In some embodiments, the skeleton line segment of each group of CPW straight line segments is determined according to location information of points in each group of CPW straight line segments. For example, one group of CPW straight line segments that include four CPW straight line segments parallel to each other are used as an example, at any two locations of one straight line segment, two straight lines perpendicular to the straight line segment are drawn, and intersections of the two straight lines and the four straight line segments form two point sets. For points in each point set, an average value of horizontal coordinates of the points is used as a horizontal coordinate, and an average value of vertical coordinates of the points is used as a vertical coordinate, to obtain a new coordinate point. A connection line of two new coordinate points is a straight line on which the skeleton line segment of the CPW straight line segments is located. For example, at a head end of a straight line segment, a straight line perpendicular to the CPW straight line segment is drawn, and intersections of the straight line and the four straight line segments form a first point set, which includes {(x1, y1}, (x2, y2), (x3, y3), (x4, y4)}; and at a tail end of each straight line segment, a straight line perpendicular to the straight line segment is drawn, and intersections of the straight line and the four straight line segments form a second point set, which includes {(x5, y5), (x6, y6), (x7, y7), (x8, y8)}. For example, for the first point set, (x1+x2+x3+x4)/4 is used as a horizontal coordinate, and (y1+y2+y3+y4)/4 is used as a vertical coordinate, to obtain a point A ((x1+x2+x3+x4)/4, (y1+y2+y3+y4)/4); and for the second point set, (x5+x6+x7+x8)/4 is used as a horizontal coordinate, (y5+y6+y7+y8)/4 is used as a vertical coordinate, to obtain a point B ((x5+x6+x7+x8)/4, (y5+y6+y7+y8)/4), and a line segment formed by the point A and the point B is a skeleton line segment of the CPW straight line segments.

In some embodiments, the skeleton line segment of each group of CPW arc line segments is determined according to parameter information of each group of CPW arc line segments. In some embodiments, an arc parameter of a CPW arc line segment may include an arrangement sequence of points of the CPW arc line segment and a value of a central angle of the CPW arc line segment; and a circle center parameter of a CPW arc line segment may include a circle center location corresponding to the CPW arc line segment and a radius length corresponding to the CPW arc line segment.

For example, the skeleton line segment of each group of CPW arc line segments is determined according to radius lengths and a circle center location corresponding to each group of CPW arc line segments. For example, one group of CPW arc line segments that include four arc line segments are used as an example, an average value of radii respectively corresponding to the four arc line segments is used as a radius of a skeleton line segment, and a circle center location of the four arc line segments is used as a circle center, to construct an arc line segment that is parallel to the four arc line segments, that is, a skeleton line segment of the CPW arc line segments. For example, the radii of the four arc line segments are respectively r1, r2, r3, and r4, where r1, r2, r3, and r4 are positive numbers, and the corresponding circle center location is a point O (x, y). In this case, an arc line segment that is parallel to the four arc line segments, namely, the skeleton line segment of the CPW arc line segments is constructed by using the point O (x, y) as a circle center and using (r1+r2+r3+r4)/4 as a radius.

In some embodiments, the skeleton line segment of each group of CPW straight line segments is determined according to location information of points in each group of CPW straight line segments. For example, one group of CPW straight line segments that include two straight line segments parallel to each other are used as an example, at any two locations of each straight line segment, two straight lines perpendicular to the straight line segment are drawn, and intersections of the two straight lines and the two straight line segments form two point sets. For points in each point set, an average value of horizontal coordinates of the points is used as a horizontal coordinate, and an average value of vertical coordinates of the points is used as a vertical coordinate, to obtain a new coordinate point. A connection line of two new coordinate points is a straight line on which the skeleton line segment of the CPW straight line segments is located. For example, at a head end of each straight line segment, a straight line perpendicular to the straight line segment is drawn, and intersections of the straight line and the two straight line segments form a first point set, which includes {(x1, y1}, (x2, y2)}; and at a tail end of each straight line segment, a straight line perpendicular to the straight line segment is drawn, and intersections of the straight line and the two straight line segments form a second point set, which includes {(x3, y3), (x4, y4)}. For example, for the first point set, (x1+x2)/2 is used as a horizontal coordinate, and (y1+y2)/2 is used as a vertical coordinate, to obtain a point A ((x1+x2)/2, (y1+y2)/2); and for the second point set, (x3+x4)/2 is used as a horizontal coordinate, (y3+y4)/2 is used as a vertical coordinate, to obtain a point B ((x3+x4)/2, (y3+y4)/2), and a line segment formed by the point A and the point B is a skeleton line segment of the CPW straight line segments.

In some embodiments, the skeleton line segment of each group of CPW arc line segments is determined according to parameter information of each group of CPW arc line segments. For example, the skeleton line segment of each group of CPW arc line segments is determined according to radius lengths and a circle center location corresponding to each group of CPW arc line segments. For example, one group of CPW arc line segments that include two arc line segments are used as an example, an average value of radii respectively corresponding to the two arc line segments is used as a radius of a skeleton line segment, and a circle center location of the two arc line segments is used as a circle center, to construct an arc line segment that is parallel to the two arc line segments, that is, a skeleton line segment of the CPW arc line segments. For example, the radii of the two arc line segments are respectively r1 and r2, and the corresponding circle center location is a point O (x, y). In this case, an arc line segment that is parallel to the two CPW arc line segments, namely, the skeleton line segment of the CPW arc line segments is constructed by using the point O (x, y) as a circle center and using (r1+r2)/2 as a radius.

The method for determining the skeleton line segment of each group of CPW straight line segments and the method for determining the skeleton line segment of each group of CPW arc line segments are not limited in the invention, and the foregoing only provides exemplary description.

Step 1350. Determine a connection sequence of the skeleton line segments according to parameter information of each CPW arc line segment, where the parameter information of each CPW arc line segment includes an arc parameter and a circle center parameter, the arc parameter indicates an arrangement sequence of points included in the CPW arc line segment, and the circle center parameter indicates a circle center location corresponding to the CPW arc line segment.

In some embodiments, the connection sequence of the skeleton line segments is determined according to a starting CPW skeleton line segment and an arrangement sequence of CPW skeleton line segments. In some embodiments, the arrangement sequence of the CPW skeleton line segments may be determined according to an arrangement sequence of the points in the CPW point set. A method for determining the starting CPW skeleton line segment is not limited in the invention.

In some embodiments, a starting CPW arc line segment is determined according to the parameter information of each CPW arc line segment. The connection sequence of the skeleton line segments is determined according to the starting CPW arc line segment and an arrangement sequence of the CPW arc line segments.

Specifically, the starting CPW arc line segment may be determined according to the arrangement sequence of the points included in each CPW arc line segment and the circle center location of each CPW arc line segment.

In some embodiments, three consecutive CPW arc line segments are determined from the CPW arc line segments, where the three consecutive CPW arc line segments include a first CPW arc line segment, a second CPW arc line segment, and a third CPW arc line segment that are arranged sequentially; and when the second CPW arc line segment meets a condition, the second CPW arc line segment is determined as the starting CPW arc line segment, where the condition includes the following: an arrangement sequence of points included in the second CPW arc line segment is reverse to an arrangement sequence of points included in the first CPW arc line segment, the arrangement sequence of the points included in the second CPW arc line segment is the same as an arrangement sequence of points included in the third CPW arc line segment, the first CPW arc line segment and the second CPW arc line segment are parallel to each other and have the same circle center location, the first CPW arc line segment and the second CPW arc line segment are located in two different gaps, and the third CPW arc line segment and the second CPW arc line segment are located in the same gap.

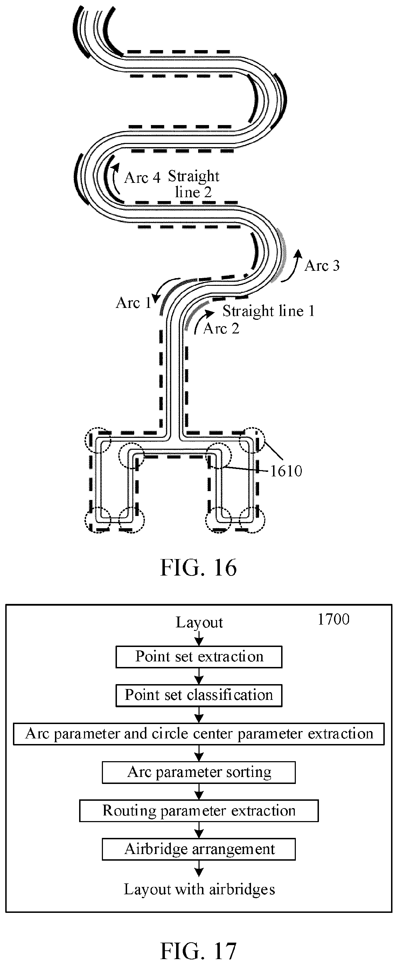

For example, as shown in FIG. 16, three consecutive CPW arc line segments are determined from the CPW arc line segments, where the three consecutive CPW arc line segments include a first CPW arc line segment (an arc 1), a second CPW arc line segment (an arc 2), and a third CPW arc line segment (an arc 3) that are arranged sequentially, and arrangement sequences of points included in the arc 1, the arc 2, and the arc 3 are shown by arrows. It can be seen that, the arrangement sequence of the points in the arc 1 is reverse to the arrangement sequence of the points in the arc 2, the arrangement sequence of the points in the arc 2 is the same as the arrangement sequence of the points in the arc 3, the arc 1 and the arc 2 have the same circle center location, a circle center location of the arc 3 is different from the circle center locations of the arc 1 and the arc 2, the arc 1 and the arc 2 are respectively located in two different gaps, and the arc 2 and the arc 3 are located in the same gap, so that the arc 2 is a starting CPW arc line segment.

For CPW arc line segments located at corners shown by 1610 in FIG. 16, since circle center locations corresponding to CPW arc line segments located in two gaps are different, when the CPW arc line segments are grouped, this type of arc line segments is not considered. That is, the CPW arc line segments located at corners shown by 1610 in FIG. 16 are not included in various groups of CPW arc line segments. This type of arc line segments is also not considered when the starting CPW arc line segment is determined. That is, the three consecutive CPW arc line segments do not include the CPW arc line segments located at corners shown by 1610 in FIG. 16, but are three consecutive CPW arc line segments obtained by arranging CPW arc line segments in each group of CPW arc line segments sequentially. According to the technical solution provided in this embodiment of the invention, according to arrangement sequences of points in any three consecutive CPW arc line segments, a starting CPW arc line segment is determined from the three CPW arc line segments, which is beneficial to ensuring the accuracy of the determined starting CPW arc line segment.

In some embodiments, a skeleton line segment corresponding to a group of CPW arc line segments in which the starting CPW arc line segment is located is used as a starting point, to determine the connection sequence of the skeleton line segments according to an arrangement sequence of the CPW arc line segments and the CPW straight line segments.

For example, as shown in FIG. 16, a skeleton line segment corresponding to a group of CPW arc line segments in which the starting CPW arc line segment (the arc 2) is located is used as a starting point, to determine the connection sequence of the skeleton line segments according to an arrangement sequence of the arc 2, a straight line 1, the arc 3, a straight line 2, and an arc 4.

Step 1360. Obtain the skeleton line of the CPW by connecting the skeleton line segment of each group of CPW straight line segments and the skeleton line segment of each group of CPW arc line segments sequentially according to the connection sequence.

According to the technical solution provided in this embodiment of the invention, the connection sequence of the skeleton line segments is determined according to the parameter information of the CPW arc line segments, so that an error in airbridge arrangement caused by error connection of the skeleton line of the CPW due to complex routing of the CPW is avoided, thereby improving the accuracy of airbridge arrangement on a chip layout.

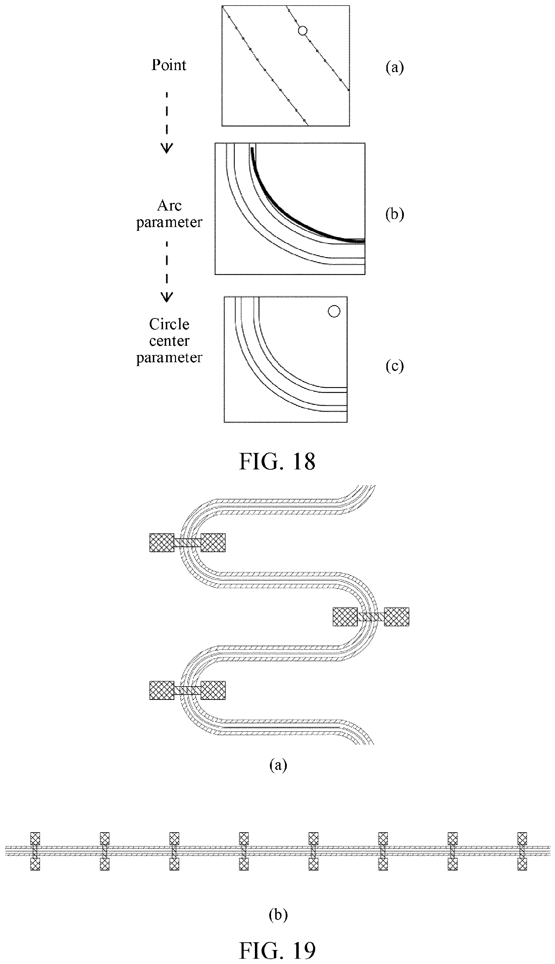

FIG. 17 is a block diagram of an airbridge arrangement method for a chip layout according to an embodiment of the invention. The method may be performed by a computer device. As shown by 1700 in FIG. 17, CPW point set extraction is first performed on the chip layout, points in the point set are then classified, and an arc parameter and a circle center parameter are respectively extracted according to different types of points. Further, sorting is performed according to the arc parameter, and airbridges are arranged according to an extracted routing parameter, to finally obtain a chip layout with airbridges. FIG. 18 is a schematic diagram of a method for determining an arc parameter and a circle center parameter according to an embodiment of the invention. After the points in the point set are classified, a corresponding arc parameter is extracted through consecutive points, and a corresponding circle center parameter is extracted through the arc parameter, so that points are converted into an arc, and the arc is then converted into a circle center. In some embodiments, FIG. 18(a) shows the points in the point set, FIG. 18(b) shows that an arc is determined according to a plurality of points, and FIG. 18(c) shows that a circle center is determined according to the arc. FIG. 19 is a schematic diagram of an airbridge arrangement method for a chip layout according to an embodiment of the invention. FIG. 19(a) shows that airbridges are arranged on arcs, and FIG. 19(b) shows that airbridges are arranged on a straight line.

The following describes apparatus embodiments of the invention, which may be configured to perform the method embodiments of the invention. For details not disclosed in the apparatus embodiments of the invention, reference may be made to the method embodiments of the invention.

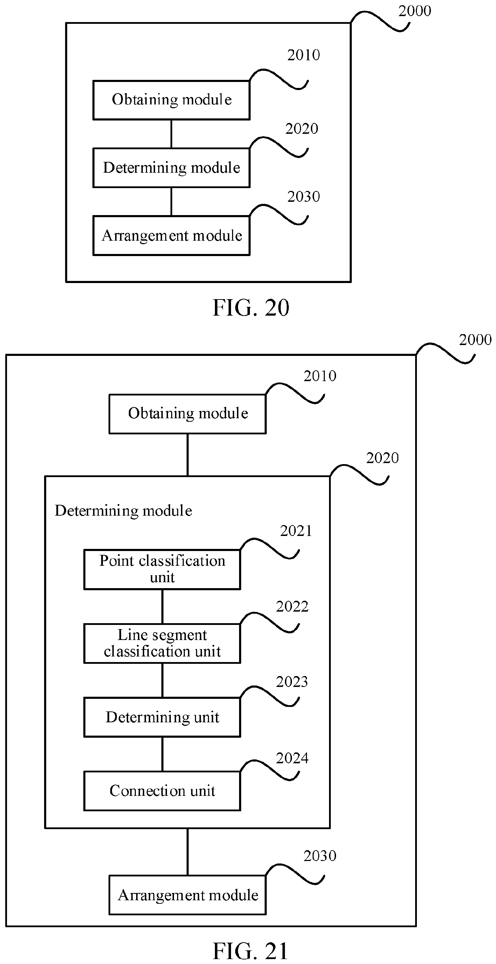

FIG. 20 is a block diagram of an airbridge arrangement apparatus for a chip layout according to an embodiment of the invention. The apparatus has a function of implementing the foregoing method examples, and the function may be implemented through hardware, or may be implemented by hardware executing corresponding software. The apparatus may be the computer device described above, or may be disposed in the computer device. As shown in FIG. 20, the apparatus 2000 includes: an obtaining module 2010, a determining module 2020, and an arrangement module 2030.

The obtaining module 2010 is configured to obtain a coplanar waveguide (CPW) point set corresponding to the chip layout, where the CPW point set includes location information of n points for defining a CPW arranged in the chip layout, and n is an integer greater than 1.

The determining module 2020 is configured to determine a skeleton line of the CPW according to the location information of the n points included in the CPW point set, where the skeleton line of the CPW is a center line of a center conductor of the CPW.

The arrangement module 2030 is configured to arrange airbridges on the chip layout according to the skeleton line of the CPW.

In some embodiments, as shown in FIG. 21, the determining module 2020 includes a point classification unit 2021, a line segment classification unit 2022, a determining unit 2023, and a connection unit 2024.

The point classification unit 2021 is configured to determine a type of each point respectively according to the location information of each point, where the type is at least one of the following: a corner point, a straight line point, or an arc point.

The line segment classification unit 2022 is configured to determine at least one group of CPW straight line segments and at least one group of CPW arc line segments according to the type and the location information of each point, where each group of CPW straight line segments correspond to two CPW straight line segments that are parallel to each other and are straight-line-shaped, and each group of CPW arc line segments correspond to two CPW arc line segments that are parallel to each other and are arc-line-shaped.

The determining unit 2023 is configured to determine a skeleton line segment of each group of CPW straight line segments and a skeleton line segment of each group of CPW arc line segments respectively.

The connection unit 2024 is configured to obtain the skeleton line of the CPW by connecting the skeleton line segment of each group of CPW straight line segments and the skeleton line segment of each group of CPW arc line segments sequentially.

In some embodiments, the connection unit 2024 is configured to: determine a connection sequence of the skeleton line segments according to parameter information of each CPW arc line segment, where the parameter information of each CPW arc line segment includes an arc parameter and a circle center parameter, the arc parameter indicates an arrangement sequence of points included in the CPW arc line segment, and the circle center parameter indicates a location of a circle center corresponding to the CPW arc line segment; and obtain the skeleton line of the CPW by connecting the skeleton line segment of each group of CPW straight line segments and the skeleton line segment of each group of CPW arc line segments sequentially according to the connection sequence.

In some embodiments, the connection unit 2024 is configured to: determine a starting CPW arc line segment according to the parameter information of each CPW arc line segment; and determine the connection sequence of the skeleton line segments according to the starting CPW arc line segment and an arrangement sequence of the CPW arc line segments.

In some embodiments, the connection unit 2024 is configured to: determine three consecutive CPW arc line segments from the CPW arc line segments, where the three consecutive CPW arc line segments include a first CPW arc line segment, a second CPW arc line segment, and a third CPW arc line segment that are arranged sequentially; and determine, when the second CPW arc line segment meets a condition, the second CPW arc line segment as the starting CPW arc line segment, where the condition includes the following: an arrangement sequence of points included in the second CPW arc line segment is reverse to an arrangement sequence of points included in the first CPW arc line segment, the arrangement sequence of the points included in the second CPW arc line segment is the same as an arrangement sequence of points included in the third CPW arc line segment, the first CPW arc line segment and the second CPW arc line segment are parallel to each other and have the same circle center location, the first CPW arc line segment and the second CPW arc line segment are located in two different CPW gaps, and the third CPW arc line segment and the second CPW arc line segment are located in the same CPW gap.

In some embodiments, the line segment classification unit 2022 is configured to: determine, according to the type and the location information of each point, a line segment in which a plurality of consecutive straight line points are located as one straight line segment, and determine an arc line in which a plurality of consecutive arc points are located as one arc line segment; determine the at least one group of CPW straight line segments according to locations and a parallel relationship of straight line segments; and determine the at least one group of CPW arc line segments according to locations and a parallel relationship of arc line segments.

In some embodiments, each point in the CPW point set is located at an edge of a CPW gap having a width; each group of CPW straight line segments include four straight line segments that are parallel to each other, two of the four straight line segments are located at two edges of one CPW gap, and the other two of the four straight line segments are located at two edges of another CPW gap; and each group of CPW arc line segments include four arc line segments that are parallel to each other and have the same circle center, two of the four arc line segments are located at two edges of one CPW gap, and the other two of the four arc line segments are located at two edges of another CPW gap.

In some embodiments, each point in the CPW point set is located on a center line of a CPW gap having a width; each group of CPW straight line segments include two straight line segments that are parallel to each other, one of the two straight line segments is located on a center line of one CPW gap, and the other of the two straight line segments are located on a center line of another CPW gap; and each group of CPW arc line segments include two arc line segments that are parallel to each other and have the same circle center, one of the two arc line segments is located on a center line of one CPW gap, and the other of the two arc line segments is located on a center line of another CPW gap.

In some embodiments, the determining unit 2023 is configured to: determine, for each group of CPW straight line segments, a center line of two CPW straight line segments that are parallel to each other and are straight-line-shaped corresponding to the group of CPW straight line segments as a skeleton line segment of the group of CPW straight line segments; and determine, for each group of CPW arc line segments, a center line of two CPW arc line segments that are parallel to each other and are arc-line-shaped corresponding to the group of CPW arc line segments as a skeleton line segment of the group of CPW arc line segments.

In some embodiments, the arrangement module 2030 is configured to arrange at least one airbridge on the chip layout along the skeleton line of the CPW according to an arrangement parameter of the airbridge, where the arrangement parameter of the airbridge defines a size of a bridge portion and a size of a pier portion of the airbridge, and a relative location relationship between the bridge portion and the pier portion.

In some embodiments, the arrangement parameter of the airbridge includes: a width of the bridge portion, a width of the pier portion, a length of the pier portion, a distance between the bridge portion and a CPW gap, and a distance between the bridge portion and the pier portion.

According to the technical solutions provided in the embodiments of the invention, for a chip layout on which a CPW has been arranged, a skeleton line of the CPW may be automatically determined according to location information of points included in a CPW point set corresponding to the chip layout, and airbridges are then arranged on the chip layout according to the skeleton line of the CPW. Therefore, location information of the skeleton line of the CPW does not need to be inputted manually, and the skeleton line of the CPW is automatically recognized and the airbridges are automatically arranged, thereby improving the versatility of the airbridge arrangement method for a chip layout.

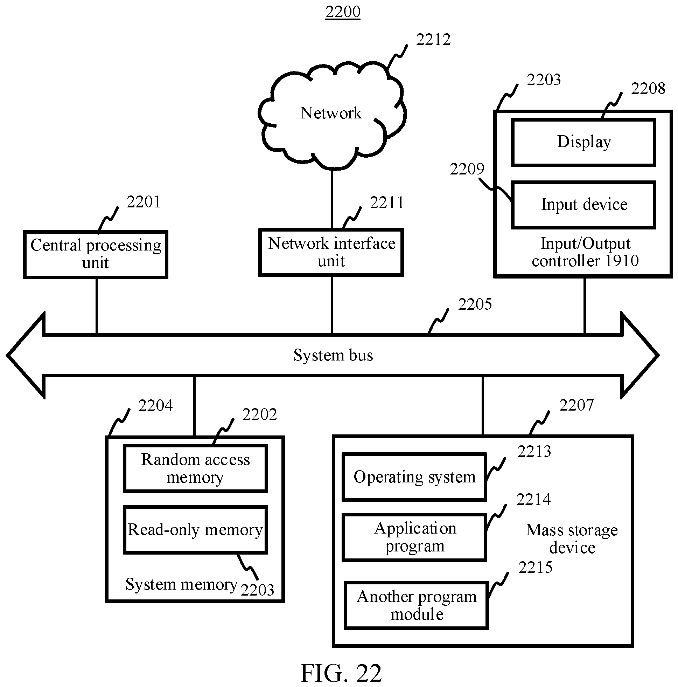

FIG. 22 is a structural block diagram of a computer device according to an embodiment of the invention. The computer device is configured to implement the airbridge arrangement method for a chip layout provided in the foregoing embodiments. Specifically:

The computer device 2200 includes a central processing unit (CPU) 2201, a system memory 2204 including a random access memory (RAM) 2202 and a read-only memory (ROM) 2203, and a system bus 2205 connecting the system memory 2204 and the central processing unit 2201. The computer device 2200 further includes a basic input/output (I/O) system 2206 configured to transmit information between components in a computer, and a mass storage device 2207 configured to store an operating system 2213, an application program 2214, and another program module 2215.

The basic input/output system 2206 includes a display 2208 configured to display information and an input device 2209 such as a mouse or a keyboard that is configured for a user to input information. The display 2208 and the input device 2209 are both connected to the central processing unit 2201 through an input/output controller 2210 connected to the system bus 2205. The basic input/output system 2206 may further include the input/output controller 2210, so as to receive and process inputs from a plurality of other devices such as a keyboard, a mouse, or an electronic stylus. Similarly, the input/output controller 2210 further provides an output to a display screen, a printer, or another type of output device.

The mass storage device 2207 is connected to the central processing unit 2201 through a mass storage controller (not shown) connected to the system bus 2205. The mass storage device 2207 and an associated computer-readable medium provide non-volatile storage for the computer device 2200. That is, the mass storage device 2207 may include a computer-readable medium (not shown) such as a hard disk or a compact disc ROM (CD-ROM) drive.

Without loss of generality, the computer-readable medium may include a computer storage medium and a communication medium. The computer storage medium includes volatile and non-volatile, removable and non-removable media that store information such as computer-readable instructions, data structures, program modules, or other data and that are implemented by using any method or technology. The computer storage medium includes a RAM, a ROM, an erasable programmable ROM (EPROM), an electrically erasable programmable ROM (EEPROM), a flash memory or another solid-state memory, a CD-ROM, a digital versatile disc (DVD) or another optical storage, a cassette, a magnetic tape, magnetic disk storage or other magnetic storage devices, or the like. Certainly, a person skilled in the art may know that the computer storage medium is not limited to the foregoing types. The system memory 2204 and the mass storage device 2207 may be collectively referred to as a memory.

According to the embodiments of the invention, the computer device 2200 may further be connected, through a network such as the Internet, to a remote computer on the network and run. That is, the computer device 2200 may be connected to a network 2212 by using a network interface unit 2211 connected to the system bus 2205, or may be connected to another type of network or remote computer system (not shown) by using the network interface unit 2211.

In an exemplary embodiment, a computer-readable storage medium is further provided, having a computer program stored therein, the computer program, when executed by a processor, implementing the airbridge arrangement method for a chip layout.

In some embodiments, the computer-readable storage medium may include: a ROM, a RAM, a solid-state drive (SSD), or an optical disc. The RAM may include a resistance RAM (ReRAM) and a dynamic RAM (DRAM).

In an exemplary embodiment, a computer program product is further provided, the computer program product including a computer program, and the computer program being stored in a computer-readable storage medium. A processor of a computer device reads the computer program from the computer-readable storage medium and executes the computer program, so that the computer device performs the airbridge arrangement method for a chip layout.

It is to be understood that "a plurality of" described in this specification refers to two or more. "And/or" describes an association relationship between associated objects and indicates that three relationships may exist. For example, A and/or B may represent the following three cases: Only A exists, both A and B exist, and only B exists. The character "/" in this specification generally represents an "or" relationship between the associated objects.

The foregoing descriptions are merely exemplary embodiments of the invention, but are not intended to limit the invention. Any modification, equivalent replacement, or improvement made within the spirit and principle of the invention shall fall within the protection scope of the invention.

## Claims

1. An airbridge arrangement method for a chip layout, executable by a computer device, the method comprising:
obtaining a coplanar waveguide (CPW) point set in the chip layout, the CPW point set comprising location information of n points for defining a CPW arranged in the chip layout, and n being an integer greater than 1;
determining a skeleton line of the CPW according to the location information of the n points comprised in the CPW point set, the skeleton line of the CPW being a center line of a center conductor of the CPW; and
arranging airbridges on the chip layout according to the skeleton line of the CPW.

2. The method according to claim 1, wherein determining the skeleton line of the CPW according to the location information of the n points comprised in the CPW point set comprises:
determining a type of each point in the n points according to the location information of the point, wherein the type is at least one of: a corner point, a straight line point, or an arc point;
determining at least one group of CPW straight line segments and at least one group of CPW arc line segments according to the type and the location information of each point, wherein each group of CPW straight line segments comprises two CPW straight line segments that are parallel to each other and are straight-line-shaped, and each group of CPW arc line segments comprises two CPW arc line segments that are parallel to each other and are arc-line-shaped;
determining a skeleton line segment of each group of CPW straight line segments and a skeleton line segment of each group of CPW arc line segments respectively; and
obtaining the skeleton line of the CPW by connecting the skeleton line segment of each group of CPW straight line segments and the skeleton line segment of each group of CPW arc line segments sequentially.

3. The method according to claim 2, wherein obtaining the skeleton line of the CPW by connecting the skeleton line segment of each group of CPW straight line segments and the skeleton line segment of each group of CPW arc line segments sequentially comprises:
determining a connection sequence of the skeleton line segments according to parameter information of each CPW arc line segment, wherein the parameter information of each CPW arc line segment comprises an arc parameter and a circle center parameter, the arc parameter indicates an arrangement sequence of points comprised in the CPW arc line segment, and the circle center parameter indicates a circle center location corresponding to the CPW arc line segment; and
obtaining the skeleton line of the CPW by connecting the skeleton line segment of each group of CPW straight line segments and the skeleton line segment of each group of CPW arc line segments sequentially according to the connection sequence.

4. The method according to claim 3, wherein determining the connection sequence of the skeleton line segments according to the parameter information of each CPW arc line segment comprises:
determining a starting CPW arc line segment according to the parameter information of each CPW arc line segment; and
determining the connection sequence of the skeleton line segments according to the starting CPW arc line segment and an arrangement sequence of the CPW arc line segments.

5. The method according to claim 4, wherein determining the starting CPW arc line segment according to the parameter information of each CPW arc line segment comprises:
determining three consecutive CPW arc line segments from the CPW arc line segments, wherein the three consecutive CPW arc line segments comprise a first CPW arc line segment, a second CPW arc line segment, and a third CPW arc line segment that are arranged sequentially; and
determining, when the second CPW arc line segment meets a condition, the second CPW arc line segment as the starting CPW arc line segment, wherein the condition comprises: an arrangement sequence of points comprised in the second CPW arc line segment is reverse to an arrangement sequence of points comprised in the first CPW arc line segment, the arrangement sequence of the points comprised in the second CPW arc line segment is the same as an arrangement sequence of points comprised in the third CPW arc line segment, the first CPW arc line segment and the second CPW arc line segment are parallel to each other and have the same circle center location, the first CPW arc line segment and the second CPW arc line segment are located in two different CPW gaps, and the third CPW arc line segment and the second CPW arc line segment are located in the same CPW gap.

6. The method according to any one of claims 2 to 5, wherein determining the at least one group of CPW straight line segments and the at least one group of CPW arc line segments according to the type and the location information of each point comprises:
determining, according to the type and the location information of each point, a line segment formed by a plurality of consecutive straight line points as a straight line segment, and determining an arc line formed by a plurality of consecutive arc points as an arc line segment;
determining the at least one group of CPW straight line segments according to locations and a parallel relationship of straight line segments; and determining the at least one group of CPW arc line segments according to locations and a parallel relationship of arc line segments.

7. The method according to claim 6, wherein each point in the CPW point set is located at an edge of a CPW gap having a width;
each group of CPW straight line segments comprise four straight line segments that are parallel to each other, two of the four straight line segments are located at two edges of one CPW gap, and the other two of the four straight line segments are located at two edges of another CPW gap; and
each group of CPW arc line segments comprise four arc line segments that are parallel to each other and have the same circle center, two of the four arc line segments are located at two edges of one CPW gap, and the other two of the four arc line segments are located at two edges of another CPW gap.

8. The method according to claim 6, wherein each point in the CPW point set is located on a center line of a CPW gap having a width;
each group of CPW straight line segments comprise two straight line segments that are parallel to each other, one of the two straight line segments is located on a center line of one CPW gap, and the other of the two straight line segments are located on a center line of another CPW gap; and
each group of CPW arc line segments comprise two arc line segments that are parallel to each other and have the same circle center, one of the two arc line segments is located on a center line of one CPW gap, and the other of the two arc line segments is located on a center line of another CPW gap.

9. The method according to any one of claims 2 to 8, wherein determining the skeleton line segment of each group of CPW straight line segments and the skeleton line segment of each group of CPW arc line segments respectively comprises:
determining, for each group of CPW straight line segments, a center line of two CPW straight line segments that are parallel to each other and are straight-line-shaped corresponding to the group of CPW straight line segments as a skeleton line segment of the group of CPW straight line segments; and
determining, for each group of CPW arc line segments, a center line of two CPW arc line segments that are parallel to each other and are arc-line-shaped corresponding to the group of CPW arc line segments as a skeleton line segment of the group of CPW arc line segments.

10. The method according to any one of claims 1 to 9, wherein arranging the airbridges on the chip layout according to the skeleton line of the CPW comprises:
arranging at least one airbridge on the chip layout along the skeleton line of the CPW according to an arrangement parameter of the at least one airbridge, wherein the arrangement parameter of the at least one airbridge defines a size of a bridge portion and a size of a pier portion of the at least one airbridge, and a relative location relationship between the bridge portion and the pier portion.

11. The method according to claim 10, wherein the arrangement parameter of the at least one airbridge comprises: a width of the bridge portion, a width of the pier portion, a length of the pier portion, a distance between the bridge portion and a CPW gap, and a distance between the bridge portion and the pier portion.

12. An airbridge arrangement apparatus for a chip layout, comprising:
an obtaining module, configured to obtain a coplanar waveguide (CPW) point set in the chip layout, the CPW point set comprising location information of n points for defining a CPW arranged in the chip layout, and n being an integer greater than 1;
a determining module, configured to determine a skeleton line of the CPW according to the location information of the n points comprised in the CPW point set, the skeleton line of the CPW being a center line of a center conductor of the CPW; and
an arrangement module, configured to arrange airbridges on the chip layout according to the skeleton line of the CPW.

13. A computer device, comprising a processor and a memory, the memory having a computer program stored therein, and the processor being configured to execute the computer program to implement the method according to any one of claims 1 to 11.

14. A computer-readable storage medium, having a computer program stored therein, the computer program being loaded and executed by a processor to implement the method according to any one of claims 1 to 11.

15. A computer program product, comprising a computer program, the computer program being loaded and executed by a processor to implement the method according to any one of claims 1 to 11.
